# EUROPEAN PATENT APPLICATION

(11) **EP 3 758 074 A1**
(43) Date of publication of application: **30.12.2020**
(21) Application number: 18887213.9
(22) Date of filing: 15.06.2018
(51) Int. Cl.: H01L 31/18, H01L 21/67

(54) **AUTOMATED WAFER SEPARATING EQUIPMENT FOR SOLAR CELLS**

(30) Priority: 24.02.2018 CN 201810156252
(71) Applicant: Eging Photovoltaic Technology Co., Ltd, Jiangsu 213213 (CN)
(72) Inventor: LU, Haifeng, Changzhou Jiangsu 213213 (CN); YUAN, Huabin, Changzhou Jiangsu 213213 (CN); SUN, Tietun, Changzhou Jiangsu 213213 (CN); YAO, Weizhong, Changzhou Jiangsu 213213 (CN); ZHANG, Kaisheng, Changzhou Jiangsu 213213 (CN)
(74) Representative: Algemeen Octrooi- en Merkenbureau B.V.
(86) International application number: PCT/CN2018/091518
(87) International publication number: WO 2019/161627

(57) **Abstract**

The present invention relates to a device for automatically distributing a wafer of a solar cell. The control part controls a basket filled with silicon wafers to be conveyed from a material uploading area to a wafer downloading area. In the wafer downloading area, the silicon wafers in the basket are unloaded and conveyed to the buffer area one by one. In the buffer area, the silicon wafers are delivered to the moving mechanism in the wafer distribution area. Then, the silicon wafers are transferred to the wafer uploading area by the wafer distribution mechanism, and are placed in the basket through the wafer uploading area. Eventually, the basket filled with silicon wafers are conveyed out through the material downloading area. In this way, it can realize wafer distribution. By automatic wafer distribution, it can effectively avoid the problems of contamination, fragmentation and scratching caused by manual taking and measuring of wafers. It can greatly improve the testing efficiency, and can complete the experimental comparison of large batches of wafers, improve the accuracy of the experiment and reduce error.

## Description

### TECHNICAL FIELD

The present invention relates to a solar cell wafer, in particular to a technical field of wafer distribution device for solar cell wafers. The present invention provides a device for automatically distributing a wafer of a solar cell.

### BACKGROUND

At present, in the field of solar cell wafers, due to the large number of production lines and complicated processes, when it is necessary to solve problems such as power, it is often necessary to carry out grouping experiments on the original wafers. Some of the original wafers are loaded through a basket, and some of them are stacked. In general, the grouping experiment needs to accurately distribute the wafers, that is, the wafers should be equally divided and staggered according to the order and the number of experimental groups required. The technician needs to distribute the wafers one by one, which is time consuming, and limits that the number of experimental groupings cannot be too large. In the process of distribution, it is easy to cause uncertainties such as pollution, scratches and fragments, which may bring more inaccuracies to the experimental results.

### SUMMARY

The technical problem to be solved by the present invention is to provide a device for automatically distributing a wafer of a solar cell, which can overcome the problems of low wafer distribution efficiency, small number of wafers to be distributed, fragmentation, scratching and contamination in the wafer distribution process in the prior a rt.

The technical solution provided by the present invention to solve the technical problem thereof is as follows. A device for automatically distributing a wafer of a solar cell includes: a material uploading area, a wafer downloading area, a buffer area, a wafer distribution area, a wafer uploading area, a material downloading area, a stack uploading area and a control part, the wafer distribution area includes a moving mechanism and a wafer distribution mechanism, a plurality of wafer distribution mechanisms are disposed perpendicular to the moving mechanism, the material uploading area, the wafer downloading area, the buffer area, the moving mechanism and the stack uploading area are sequentially arranged in a pipeline, the wafer distribution mechanism, the wafer uploading area and the material downloading area are sequentially arranged in a pipeline, the control part respectively controls the material uploading area, the wafer downloading area, the buffer area, the wafer distribution area, the wafer uploading area, the material downloading area and the stack uploading area.

In the device for automatically distributing a wafer of a solar cell, the control part controls a basket filled with silicon wafers to be conveyed from a material uploading area to a wafer downloading area. In the wafer downloading area, the silicon wafers in the basket are unloaded and conveyed to the buffer area one by one. In the buffer area, the silicon wafers are delivered to the moving mechanism in the wafer distribution area. Then, the silicon wafers are transferred to the wafer uploading area by the wafer distribution mechanism, and are placed in the basket through the wafer uploading area. Eventually, the basket filled with silicon wafers are conveyed out through the material downloading area. In this way, it can realize wafer distribution. By automatic wafer distribution, it can effectively avoid the problems of contamination, fragmentation and scratching caused by manual taking and measuring of wafers. It can greatly improve the testing efficiency, and can complete the experimental comparison of large batches of wafers, improve the accuracy of the experiment and reduce error.

Further, the material uploading area includes a transport device, two sets of transport devices are vertically spaced apart, a light sensor is fixedly mounted on the right side of the transport device, and the light sensor is electrically connected to the control part. The upper transport device is used to transport a basket filled with silicon wafers, and the lower transport device is used to transport an empty basket.

Further, the wafer downloading area includes a wafer downloading device, a clamping device and a conveying device, the wafer downloading device includes a linkage device and a fixed table, the linkage device drives the fixed table up and down, the clamping device is fixedly mounted above the fixed table, the conveying device includes a transport device and a movable conveying device, the transport device is fixedly mounted on the fixed table and located directly below the clamping device, and the movable conveying device is disposed between the clamping device and the transport device.

Further, the buffer area includes a linkage device, a transport device and a storage basket, the storage basket shrouds the transport device, and the linkage device drives the storage basket up and down.

Preferably, the storage basket includes a positioning board, two positioning boards are arranged in parallel and with an interval, the transport device is located between the two positioning boards, the positioning board is provided with a plurality of buffer slots, the buffer slots on the two positioning boards are arranged in a one-to-one correspondence, left and right photoelectric sensors are fixedly mounted on the positioning board, the left and right photoelectric sensors are located at both ends of the buffer slots, and the left and right photoelectric sensors are both electrically connected to the control part.

Further, the moving mechanism includes a transport device and a drive device, a plurality of photoelectric sensors are disposed at intervals above the transport device along the transport direction of the transport device, the plurality of photoelectric sensors are all electrically connected to the control part, and the driving device drives the transport device up and down. After all of the plurality of photoelectric sensors detect a wafer of a solar cell, the control part controls the driving device up and down, and the driving device drives the transport device up and down.

Further, the wafer distribution mechanism includes a wafer distribution track group, a transport device and a guiding device, a plurality of wafer distribution track groups are all disposed perpendicular to the moving mechanism, the plurality of wafer distribution track groups are disposed corresponding to the plurality of photoelectric sensors in a one-to-one correspondence, and each wafer distribution track group corresponds to a set of transport device, the guiding device is located above the transport device and configured to correct the cell wafer during the conveying process.

Further, the wafer uploading area includes a wafer uploading device, a clamping device and a conveying device, the wafer uploading device includes a linkage device and a fixed table, the linkage device drives the fixed table up and down, the clamping device is fixedly mounted above the fixed table, the conveying device includes a transport device and a movable conveying device, the transport device is fixedly mounted on the fixed table and located directly below the clamping device, and the movable conveying device is disposed between the clamping device and the transport device.

Further, the material downloading area includes a transport device, two sets of transport devices are vertically spaced apart, a photoelectric sensor is fixedly mounted on the right side of the transport device, and the photoelectric sensor is electrically connected to the control part.

Further, the stack uploading area includes a stack receiving basket, a transport device, a linkage device, a driving device, and a suction cup, the stack receiving basket is located at one side of the transport device, the linkage device is located directly above the transport device for driving a lifting device to move forward or backward of the transport device, the driving device is slidably mounted on the linkage device, and the suction cup is fixedly mounted on the lifting device.

Further, the clamping device includes a driving device, the driving device is fixedly mounted above the fixed table, the driving device is fixedly mounted with a clamping plate, the clamping plate is located directly above the transport device, and the driving device drives the clamping plate closer to or away from the transport device.

Further, the movable conveying device includes a frame and a belt, the frame is fixedly mounted with a first rotating shaft and a second rotating shaft, a third rotating shaft and a fourth rotating shaft are slidably mounted on the frame, the first rotating shaft and the fourth rotating shaft are located on the same horizontal plane, the first rotating shaft, the second rotating shaft, the third rotating shaft and the fourth rotating shaft each are fixedly mounted with a pulley, the belt is wound sequentially around the pulleys on the first rotating shaft, the second rotating shaft, the third rotating shaft, and the four rotating shaft, the frame is fixedly mounted with a pushing cylinder, protruding ends of two pushing cylinders are fixedly connected to the third rotating shaft and the fourth rotating shaft respectively, the two pushing cylinders respectively drive the third rotating shaft and the fourth rotating shaft to move left and right on the frame, the frame is fixedly mounted with a pressure sensor, the pressure sensor is located on the left side of the fourth rotating shaft, and the pressure sensor is electrically connected to the control part.

In order to simplify the overall mounting structure of the present invention, the transport device is a belt conveyor having two groups of conveying tracks in parallel and spaced apart, and the belt conveyor is electrically connected to the control part.

In order to simplify the overall mounting structure of the present invention, the linkage device is a screw drive device that is electrically connected to the control part.

Further, the wafer distribution track group includes two U-shaped plates in parallel and spaced apart, one of the U-shaped plates is inserted between two groups of conveying tracks in the belt conveyor of the moving mechanism, a conveying track is disposed on the U-shaped plate for driving the cell wafer to move, and the conveying track is electrically connected to the control part.

Further, the guiding device includes a guiding plate, and two guiding plates are respectively located on two sides of the transport device, the two guiding plates are all arranged in parallel to the transport device, and the guiding plate is provided with a guide opening, and two guide openings are symmetrically arranged.

Preferably, the control part is a programmable logic controller.

The beneficial effects of the invention are as follows. In the device for automatically distributing a wafer of a solar cell, the control part controls a basket filled with silicon wafers to be conveyed from a material uploading area to a wafer downloading area. In the wafer downloading area, the silicon wafers in the basket are unloaded and conveyed to the buffer area one by one. In the buffer area, the silicon wafers are delivered to the moving mechanism in the wafer distribution area. Then, the silicon wafers are transferred to the wafer uploading area by the wafer distribution mechanism, and are placed in the basket through the wafer uploading area. Eventually, the basket filled with silicon wafers are conveyed out through the material downloading area. In this way, it can realize wafer distribution. By automatic wafer distribution, it can effectively avoid the problems of contamination, fragmentation and scratching caused by manual taking and measuring of wafers. It can greatly improve the testing efficiency, and can complete the experimental comparison of large batches of wafers, improve the accuracy of the experiment and reduce error.

### BRIEF DESCRIPTION OF THE DRAWINGS

The present invention will now be further described with reference to the drawings and embodiments.
Fig. 1 is a top view of the present invention;
Fig. 2 is a three dimensional schematic diagram of a material uploading area (a material downloading area) of the present invention;
Fig. 3 is a three dimensional schematic diagram of a wafer downloading area (a wafer uploading area) of the present invention;
Fig. 4 is a three dimensional schematic diagram of a buffer area of the present invention;
Fig. 5 is an enlarged view of a portion A in Fig. 4 of the present invention;
Fig. 6 is a three dimensional schematic diagram of a wafer distribution area in the present invention;
Fig. 7 is a three dimensional schematic diagram of a moving mechanism in a wafer distribution area of the present invention; and
Fig. 8 is a three dimensional schematic diagram of a wafer distribution mechanism in the wafer distribution area of the present invention.

In the drawings: 1. material uploading area, 2. wafer downloading area, 2-1. fixed table, 3. buffer area, 3-1. positioning board, 3-2. buffer slot, 4. wafer distribution area, 4-1. moving mechanism, 4-2. wafer distribution mechanism, 4-2-1. U-shaped plate, 4-2-2. guiding plate, 4-2-2-1. guide opening, 4-2-3. conveying track, 5. stack uploading area, 5-1. stack receiving basket, 5-2. suction cup, 6. wafer uploading area, 6-1 clamping plate, 6-2. belt, 6-3. first rotating shaft, 6-4. second rotating shaft, 6-5. third rotating shaft, 6-6. fourth rotating shaft, 6-7. pulley, 7 material downloading area, 8. belt conveyor, 9. screw drive device, 10. cylinder, 11. photoelectric sensor.

### DETAILED DESCRIPTION

The present invention will now be described in further detail with reference to the drawings. These drawings are simplified schematic diagrams. The basic structure of the present invention is explained only in a schematic manner, and therefore only the configuration related to the present invention is shown.

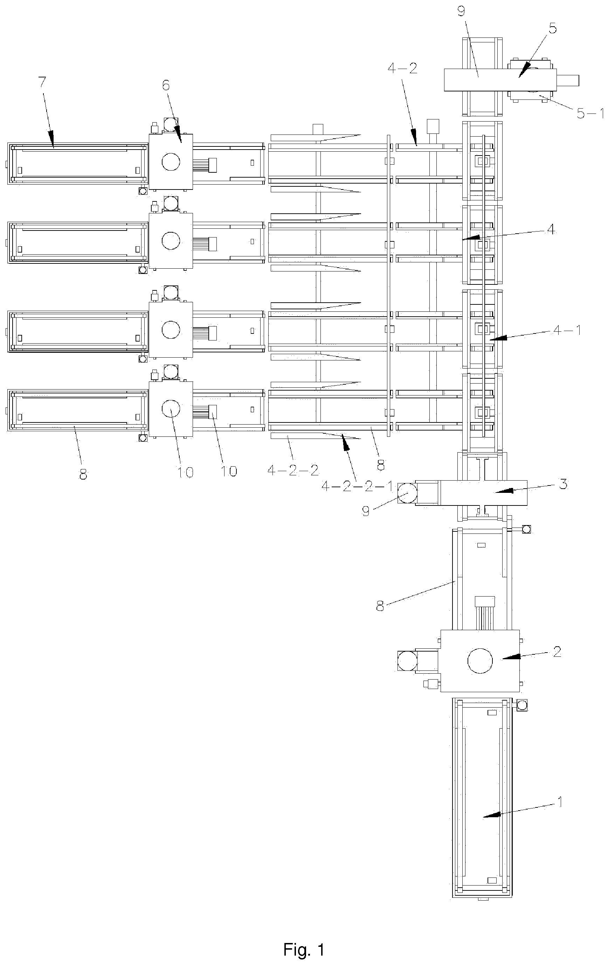

As shown in Fig. 1, a device for automatically distributing a wafer of a solar cell includes a material uploading area 1, a wafer downloading area 2, a buffer area 3, a wafer distribution area 4, a wafer uploading area 6, a material downloading area 7, a stack uploading area 5, and a control part. The wafer distribution area 4 includes a moving mechanism 4-1 and a wafer distribution mechanism 4-2, and the plurality of the wafer distribution mechanisms 4-2 are disposed perpendicular to the moving mechanism 4-1. The material uploading area 1, the wafer downloading area 2, the buffer area 3, the moving mechanism 4-1 and the stack uploading area 5 are sequentially arranged in a pipeline, and the wafer distribution mechanism 4-2, the wafer uploading area 6 and the material downloading area 7 are sequentially arranged in a pipeline, and the control part respectively controls the material uploading area 1, the wafer downloading area 2, the buffer area 3, the wafer distribution area 4, the wafer uploading area 6, the material downloading area 7, and the stack uploading area 5.

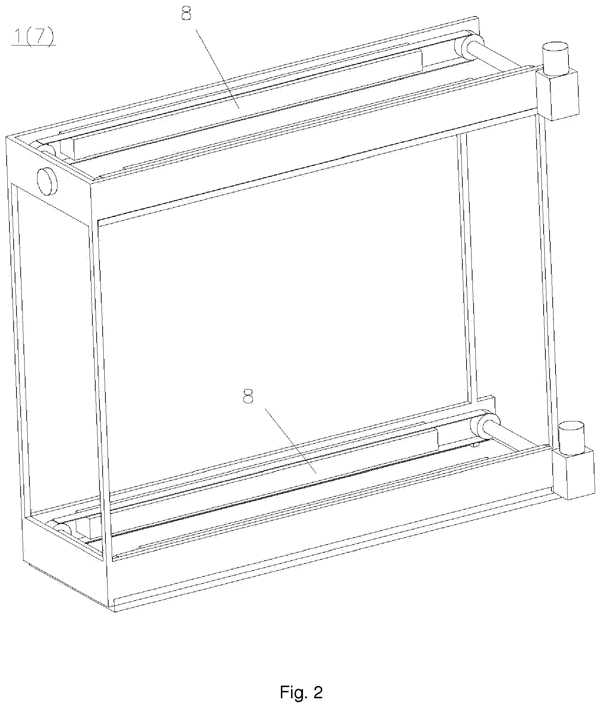

As shown in Fig. 2, the material uploading area 1 includes a belt conveyor 8. Two sets of the belt conveyors 8 are vertically spaced apart. A light sensor is fixedly mounted on the right side of the belt conveyor 8. The light sensor is electrically connected to the control part. The upper belt conveyor 8 is used to transport a basket filled with silicon wafers, and the lower belt conveyor 8 is used to transport an empty basket.

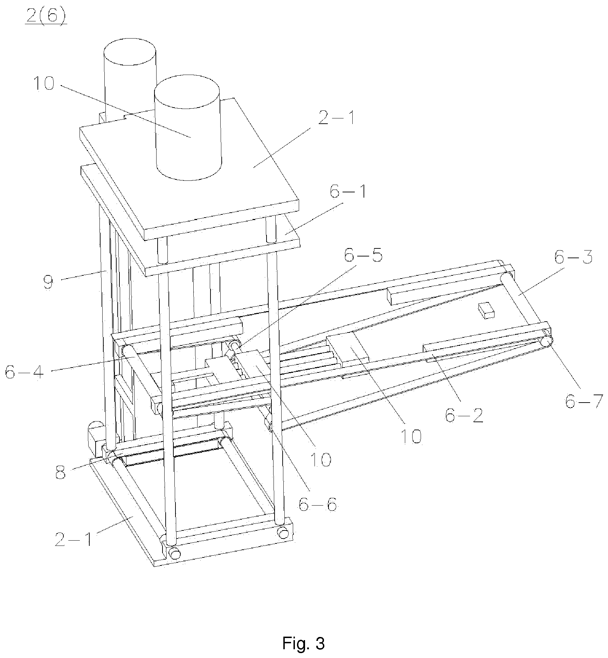

As shown in Fig. 3, the wafer downloading area 2 includes a wafer downloading device, a clamping device and a conveying device. The wafer downloading device includes a screw drive device 9 and a fixed table 2-1. The screw drive device 9 drives the fixed table 2-1 up and down. The clamping device is fixedly mounted above the fixed table 2-1. The conveying device includes a belt conveyor 8 and a movable conveying device. The transport device is fixedly mounted on the fixed table 2-1 and located directly below the clamping device. The movable conveying device is disposed between the clamping device and the belt conveyor 8. The clamping device includes a driving device, which is a cylinder 10. The driving device is fixedly mounted above the fixed table 2-1, and the driving device is fixedly mounted with a clamping plate 6-1. The clamping plate 6-1 is located directly above the belt conveyor 8. The driving device drives the clamping plate 6-1 closer to or away from the belt conveyor 8. The movable conveying device includes a frame and a belt 6-2. The frame is fixedly mounted with a first rotating shaft 6-3 and a second rotating shaft 6-4, and a third rotating shaft 6-5 and a fourth rotating shaft 6-6 are slidably mounted on the frame. The first rotating shaft 6-3 and the fourth rotating shaft 6-6 are located on the same horizontal plane, the first rotating shaft 6-3, the second rotating shaft 6-4, and the third rotating shaft 6-5 and the fourth rotating shaft 6-6 each are fixedly mounted with a pulley 6-7. The belt 6-2 is wound sequentially around the pulleys 6-7 on the first rotating shaft 6-3, the second rotating shaft 6-4, the third rotating shaft 6-5, and the four rotating shaft 6-6. The frame is fixedly mounted with a pushing cylinder. The pushing cylinder is a cylinder 10. Protruding ends of two cylinders 10 are fixedly connected to the third rotating shaft 6-5 and the fourth rotating shaft 6-6 respectively. The two cylinders 10 respectively drive the third rotating shaft 6-5 and the fourth rotating shaft 6-6 to move left and right on the frame. The frame is fixedly mounted with a pressure sensor. The pressure sensor is located on the left side of the fourth rotating shaft 6-6, and the pressure sensor is electrically connected to the control part.

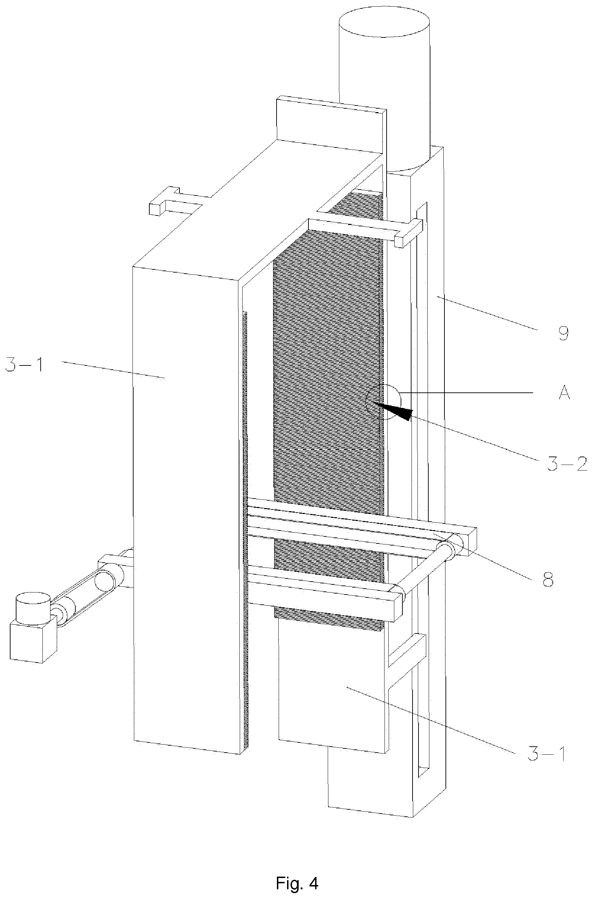

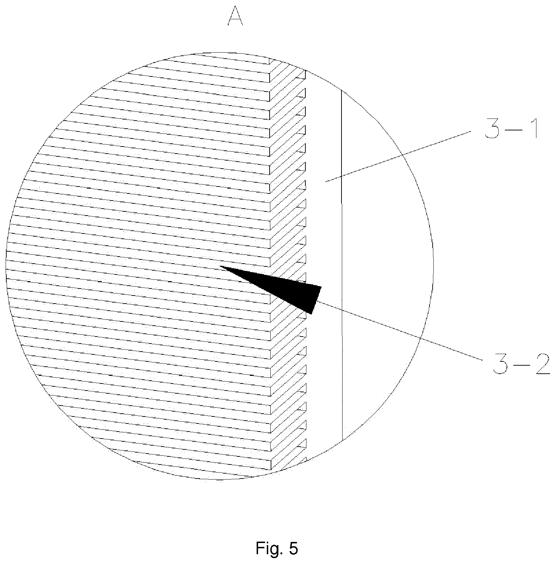

As shown in Fig. 4, the buffer area 3 and the buffer area 3 both include a screw drive device 9 and a belt conveyor 8 and a storage basket. The storage basket shrouds the belt conveyor 8. The screw drive device 9 drives the storage basket up and down. The storage basket includes a positioning board 3-1. Two positioning boards 3-1 are arranged in parallel and with an interval. The belt conveyor 8 is located between the two positioning boards 3-1. The positioning board 3-1 is provided with a plurality of buffer slots 3-2, as shown in the Fig. 5, and the buffer slots 3-2 on the two positioning boards 3-1 are arranged in a one-to-one correspondence. Left and right photoelectric sensors 11 are fixedly mounted on the positioning board 3-1. The left and right photoelectric sensors are located at both ends of the buffer slots 3-2.

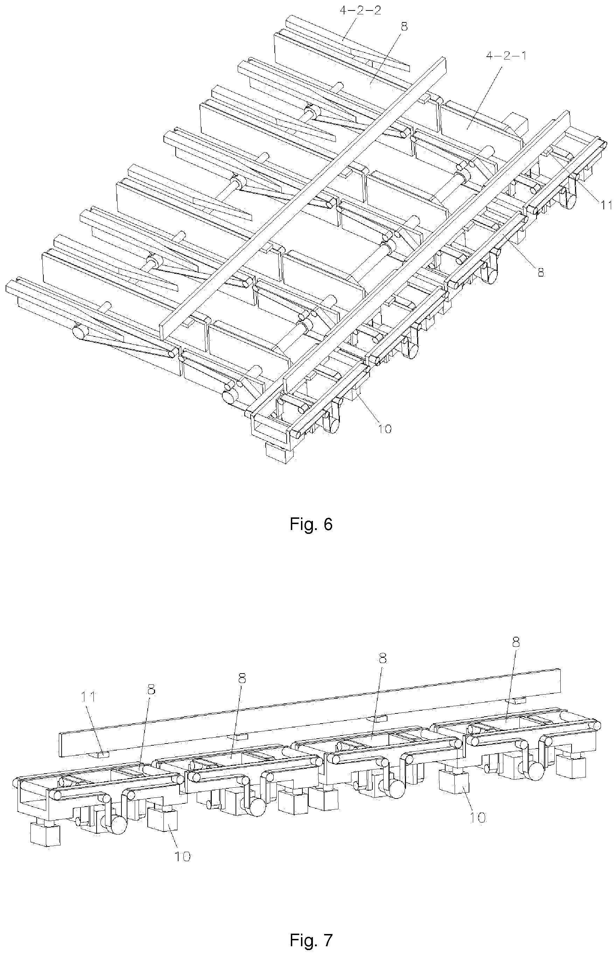

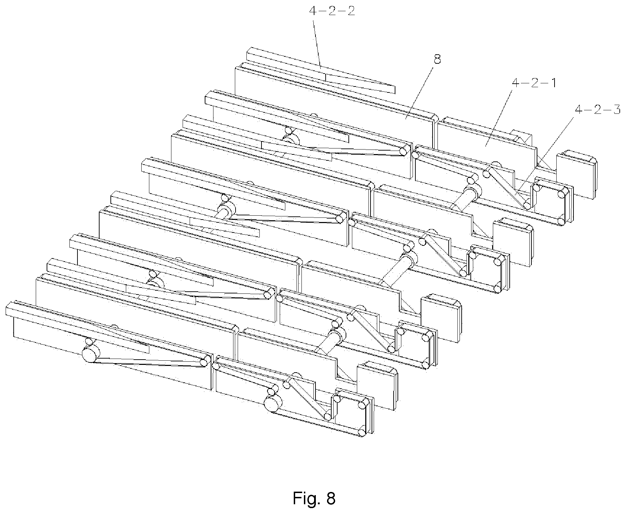

As shown in Fig. 6, the wafer distribution area 4 includes a moving mechanism 4-1 and a wafer distribution mechanism 4-2. Four groups of wafer distribution mechanisms 4-2 are all disposed perpendicular to the moving mechanism 4-1. The moving mechanism 4-1 includes four belt conveyors 8 and eight cylinders 10, as shown in Fig. 7. The four belt conveyors 8 are disposed in sequence, each belt conveyors 8 having cylinders 10 disposed at both ends, and a photoelectric sensor 11 disposed above each belt conveyor 8. The four photoelectric sensors 11 are all electrically connected to the control part. The cylinder 10 drives the belt conveyor 8 up and down. After all of the plurality of photoelectric sensors 11 detect a wafer of a solar cell, the control part controls the cylinders 10 up and down, and the cylinders 10 drive the belt conveyor 8 up and down. The wafer distribution mechanism 4-2 includes a wafer distribution track group, a belt conveyor 8 and a guiding device, as shown in Fig. 8. The four wafer distribution track groups are all disposed perpendicular to the belt conveyor 8 in the moving mechanism 4-1. The four wafer distribution track groups are disposed corresponding to the four photoelectric sensors 11 in one-to-one correspondence, and each wafer distribution track group corresponds to a set of belt conveyor 8. The guiding device is located above the transport device and configured to correct the cell wafer during the conveying process. The wafer distribution track group includes two U-shaped plates 4-2-1 in parallel and spaced apart. One of the U-shaped plates 4-2-1 is inserted between two groups of conveying tracks 4-2-3 in the belt conveyor 8 of the moving mechanism 4-1. A conveying track 4-2-3 is disposed on the U-shaped plate 4-2-1 for driving the cell wafer to move. The conveying track 4-2-3 is electrically connected to the control part. The guiding device includes a guiding plate 4-2-2, and two guiding plates 4-2-2 are respectively located on two sides of the belt conveyor 8. The two guiding plates 4-2-2 are all arranged in parallel to the belt conveyor 8. The guiding plate 4-2-2 is provided with a guide opening 4-2-2-1, and two guide openings 4-2-2-1 are symmetrically arranged.

As shown in Fig. 4, the wafer uploading area 6 includes a wafer uploading device, a clamping device and a conveying device. The wafer uploading device includes a screw drive device 9 and a fixed table 2-1. The screw drive device 9 drives the fixed table 2-1 up and down. The clamping device is fixedly mounted above the fixed table 2-1. The conveying device includes a belt conveyor 8 and a movable conveying device. The transport device is fixedly mounted on the fixed table 2-1 and located directly below the clamping device. The movable conveying device is disposed between the clamping device and the belt conveyor 8. The clamping device includes a driving device, which is a cylinder 10. The driving device is fixedly mounted above the fixed table 2-1, and the driving device is fixedly mounted with a clamping plate 6-1. The clamping plate 6-1 is located directly above the belt conveyor 8. The driving device drives the clamping plate 6-1 closer to or away from the belt conveyor 8. The movable conveying device includes a frame and a belt 6-2. The frame is fixedly mounted with a first rotating shaft 6-3 and a second rotating shaft 6-4, and a third rotating shaft 6-5 and a fourth rotating shaft 6-6 are slidably mounted on the frame. The first rotating shaft 6-3 and the fourth rotating shaft 6-6 are located on the same horizontal plane, the first rotating shaft 6-3, the second rotating shaft 6-4, the third rotating shaft 6-5 and the fourth rotating shaft 6-6 each are fixedly mounted with a pulley 6-7. The belt 6-2 is wound sequentially around the pulleys 6-7 on the first rotating shaft 6-3, the second rotating shaft 6-4, the third rotating shaft 6-5, and the four rotating shaft 6-6. The frame is fixedly mounted with a pushing cylinder. The pushing cylinder is a cylinder 10. Protruding ends of two cylinders 10 are fixedly connected to the third rotating shaft 6-5 and the fourth rotating shaft 6-6 respectively. The two cylinders 10 respectively drive the third rotating shaft 6-5 and the fourth rotating shaft 6-6 to move left and right on the frame. The frame is fixedly mounted with a pressure sensor. The pressure sensor is located on the left side of the fourth rotating shaft 6-6, and the pressure sensor is electrically connected to the control part.

As shown in Fig. 3, the material downloading area 7 includes a belt conveyor 8. Two sets of the belt conveyors 8 are vertically spaced apart. A light sensor is fixedly mounted on the right side of the belt conveyor 8. The light sensor is electrically connected to the control part.

The stack uploading area 5 includes a stack receiving basket 5-1, a belt conveyor 8, a screw drive device 9, a cylinder 10, and a suction cup 5-2. The stack receiving basket 5-1 is located at one side of the belt conveyor 8. The screw drive device 9 is located directly above the belt conveyor 8 for driving the cylinder 10 to move forward or backward of the transport device. The cylinder 10 is slidably mounted on the screw drive device 9. The suction cup 5-2 is fixedly mounted at an extended end of the cylinder 10.

The control part is a programmable logic controller, briefly referred to as PLC.

The working steps of the present invention are as follows.
1. After distribution and downloading the materials, the basket is placed on the belt conveyor 8 on the upper side of the material uploading area 1 to prepare for testing.
2. The PLC controls the belt conveyor 8 on the upper side of the material uploading area 1 to work and move the basket to the right. When the basket is moved to the light sensor at the right side, the PLC controls the belt conveyor 8 in the material uploading area 1 to stop working. At this time, the basket arrives at the most right end of the material uploading area 1.
3. The PLC controls the screw drive device 9 in the wafer downloading area 2 to work, and move the fixed table 2-1 upward by a fixed distance, so that the conveying surface of the belt conveyor 8 on the fixed table 2-1 and the conveying surface of the belt conveyor 8 on the upper side of the material uploading area 1 are kept at the same level.
4. The PLC controls the belt conveyor 8 on the upper side of the material uploading area 1 and the belt conveyor 8 in the wafer downloading area 2 to work, and the basket continues to move to the right to the belt conveyor 8 in the wafer downloading area 2, until the basket arrives at the most right side of the wafer downloading area 2. Then, the PLC controls the belt conveyor 8 on the upper side of the material uploading area 1 and the belt conveyor 8 in the wafer downloading area 2 to stop working.
5. The PLC controls the cylinder 10 on the wafer downloading area 2 to be inflated, the cylinder 10 moves the clamping plate 6-1 downward and fits with the upper surface of the basket, thereby clamping the basket on the fixed table 2-1.
6. The PLC controls the screw drive device 9 on the wafer downloading area 2 to work and drive the fixed table 2-1 to move down by a fixed distance, so that the silicon wafer at the most bottom side of the basket is at the same level as the belt 6-2 in the movable conveying device.
7. The PLC controls the two cylinders 10 in the movable conveying device to simultaneously extend to push the third rotating shaft 6-5 and the fourth rotating shaft 6-6 to move to the basket, so that the belt 6-2 in the movable conveying device is located below the basket, so that the belt 6-2 is brought to below the silicon wafer at the most bottom side of the basket. At this time, the pressure sensor on the left side of the movable conveying device senses a pressure.
8. The PLC controls the belt conveyor 8 in the movable conveying device to work when the pressure sensed by the pressure sensor changes from zero to a pressure.
9. When the pressure sensed by the pressure sensor changes from a pressure to zero, the PLC controls the screw drive device 9 in the wafer downloading area 2 to work and make the basket to move downward by a fixed distance every second, until the pressure sensed by the pressure sensor changes from zero to a pressure. Then, the belt conveyor 8 in the movable conveying device works again, repeats the process until the silicon wafers in the basket are all transferred to the buffer area 3.
10. The PLC controls the screw drive device 9 on the wafer downloading area 2 to bring the fixed table 2-1 to move downward until the conveying surface of the belt conveyor 8 on the fixed table 2-1 and the conveying surface of the belt conveyor 8 on the lower side of the material uploading area 1 are kept at the same level, so that after the cylinder 10 in the clamping device returns to the original position, the belt conveyor 8 on the fixed table 2-1 is operated in a reverse direction to convey the empty basket to the belt conveyor 8 on the lower side of the material uploading area 1, thereby completing a cycle of the material uploading by the basket.
11. The conveyed silicon wafer enters the buffer area 3. If the silicon wafer stays in the buffer area 3 for a long time (and the sensor on the right side of the buffer area 3 senses a pressure for a long time), the PLC controls the screw drive device 9 in the buffer area 3 to bring the storage basket to move upward by a distance, to load the silicon wafer into the buffer slot 3-2; if the silicon wafer does not pass through the buffer area 3 for a long time (and the sensor on the left side of the buffer area 3 senses no pressure for a long time), the PLC controls the screw drive device 9 in the buffer area 3 to bring the storage basket to move downward by a distance to unload the silicon wafer to the belt 6-2 of the belt conveyor 8 in the buffer area 3. The PLC sends the silicon wafer to the moving mechanism 4-1 of the wafer distribution area 4 through the belt conveyor 8 in the control buffer area 3.
12. When the silicon wafer passes the belt conveyor 8 at the most left side of the moving mechanism 4-1, the photoelectric sensor 11 above the leftmost belt conveyor 8 detects the silicon wafer, and the PLC controls the second belt conveyor 8 to operate the motor. When the wafer is conveyed and arrives at the second belt conveyor 8, the PLC controls the third belt conveyor 8 to operate the motor, and so on so forth. When the wafer arrives at the belt conveyor 8 at the most right side, the motor controls the rightmost belt conveyor 8 to stop operation. Then, after the photoelectric sensor above the third belt conveyor 8 senses that there is a wafer, the motor of the third belt conveyor 8 stops conveying, and so on so forth, until the motor of the leftmost belt conveyor 8 stops conveying. At this time, each of the belt conveyors 8 has one piece of silicon wafer thereon.
13. When all the photoelectric sensors 11 in the moving mechanism 4-1 sense that there is a silicon wafer, the cylinder 10 controls the four belt conveyors 8 to move downward at the same time, so that the silicon wafers fall in the conveying tracks 4-2-3 of the wafer distribution track groups in the wafer distribution mechanism 4-2.
14. The PLC controls all the conveying tracks 4-2-3 in all the wafer distribution track groups to work. The belt 6-2 drives the silicon wafers into the belt conveyors 8 and to pass through the guiding plates 4-2-2 located on both sides of the belt conveyors 8 to be guided to the wafer uploading area 6.
15. When the silicon wafers successively pass through the wafer uploading area 6 and the material downloading area 7, the working principle is similar to that in the wafer downloading area 2 and the material uploading area 1.
16. When loading is performed in the stack uploading area 5, stacked silicon wafers are placed in the stack receiving basket 5-1. The suction cup 5-2 above the stack receiving basket 5-1 is also moved up and down by the cylinder 10. After the suction cup 5-2 moves down to suck onto the silicon wafer, the suction cup 5-2 moves upward. The belt conveyor 8 works to bring the silicon wafer to move to the upper side of the belt conveyor 8. Then the cylinder10 moves the suction cup 5-2 downwards. After the suction cup 5-2 puts the silicon wafer on the belt 6-2, the silicon wafer is conveyed to the wafer distribution area 4 one by one. The principle is similar to the above 12th step.

In view of the above-described embodiments of the present invention, from the above description, various changes and modifications can be made by those skilled in the art without departing from the scope of the invention. The technical scope of the present invention is not limited to the contents of the specification, and the technical scope thereof should be determined according to the scope of the claims.

## Claims

1. A device for automatically distributing a wafer of a solar cell, **characterized in that** the device comprises:
• a material uploading area (1),
• a wafer downloading area (2),
• a buffer area (3),
• a wafer distribution area (4),
• a wafer uploading area (6),
• a material downloading area (7),
• a stack uploading area (5) and
• a control part, wherein
the wafer distribution area (4) comprises a moving mechanism (4-1) and a wafer distribution mechanism (4-2), and
a plurality of wafer distribution mechanisms (4-2) are disposed perpendicular to the moving mechanism (4-1), wherein
the material uploading area (1), the wafer downloading area (2), the buffer area (3), the moving mechanism (4-1) and the stack uploading area (5) are sequentially arranged in a pipeline, wherein
the wafer distribution (4-2), the wafer uploading area (6) and the material downloading area (7) are sequentially arranged in a pipeline, and wherein
the control part respectively controls the material uploading area (1), the wafer downloading area (2), the buffer area (3), the wafer distribution area (4), the wafer uploading area (6), the material downloading area (7) and the stack uploading area (5).

2. The device for automatically distributing a wafer of a solar cell according to claim 1, **characterized in that** the material uploading area (1) comprises a transport device, two sets of transport devices are vertically spaced apart, and a light sensor is fixedly mounted on the right side of the transport device, and the light sensor is electrically connected to the control part.

3. The device for automatically distributing a wafer of a solar cell according to claim 1, **characterized in that** the wafer downloading area (2) comprises a wafer downloading device, a clamping device and a conveying device, wherein the wafer downloading device comprises a linkage device and a fixed table (2-1), with the linkage device being arranged in driving the fixed table (2-1) up and down, wherein the clamping device is fixedly mounted above the fixed table (2-1), and the conveying device comprises a transport device and a movable conveying device, wherein the transport device is fixedly mounted on the fixed table (2-1) and located directly below the clamping device, and the movable conveying device is disposed between the clamping device and the transport device.

4. The device for automatically distributing a wafer of a solar cell according to claim 1, **characterized in that** the buffer area (3) comprises a linkage device, a transport device and a storage basket, wherein the storage basket shrouds the transport device, and the linkage device is arranged in driving the storage basket up and down.

5. The device for automatically distributing a wafer of a solar cell according to claim 4, **characterized in that** the storage basket comprises a positioning board (3-1), two positioning boards (3-1) are arranged in parallel and with an interval, wherein the transport device is located between the two positioning boards (3-1), the positioning board (3-1) is provided with a plurality of buffer slots (3-2), the buffer slots (3-2) on the two positioning boards (3-1) are arranged in a one-to-one correspondence, left and right photoelectric sensors (11) are fixedly mounted on the positioning board (3-1), the left and right photoelectric sensors (11) are located at both ends of the buffer slots (3-2), and the left and right photoelectric sensors are both electrically connected to the control part.

6. The device for automatically distributing a wafer of a solar cell according to claim 1, **characterized in that** the moving mechanism (4-1) comprises a transport device and a drive device, wherein a plurality of photoelectric sensors (11) are disposed at intervals above the transport device along the transport direction of the transport device, and the plurality of photoelectric sensors (11) are all electrically connected to the control part, and the driving device is arranged in driving the transport device up and down.

7. The device for automatically distributing a wafer of a solar cell according to claim 6, **characterized in that** the wafer distribution mechanism (4-2) comprises a wafer distribution track group, a transport device and a guiding device, wherein a plurality of wafer distribution track groups are all disposed perpendicular to the moving mechanism (4-1), the plurality of wafer distribution track groups are disposed corresponding to the plurality of photoelectric sensors (11) in a one-to-one correspondence, and each wafer distribution track group corresponds to a set of transport device, wherein the guiding device is located above the transport device and configured to correct the cell wafer during the conveying process.

8. The device for automatically distributing a wafer of a solar cell according to claim 1, **characterized in that** the wafer uploading area (6) comprises a wafer uploading device, a clamping device and a conveying device, wherein the wafer uploading device comprises a linkage device and a fixed table (2-1), wherein the linkage device is arranged in driving the fixed table (2-1) up and down, wherein the clamping device is fixedly mounted above the fixed table (2-1), the conveying device comprises a transport device and a movable conveying device, and the transport device is fixedly mounted on the fixed table (2-1) and located directly below the clamping device, and the movable conveying device is disposed between the clamping device and the transport device.

9. The device for automatically distributing a wafer of a solar cell according to claim 1, **characterized in that** the material downloading area (7) comprises a transport device, two sets of transport devices are vertically spaced apart, and wherein a photoelectric sensor (11) is fixedly mounted on the right side of the transport device, and the photoelectric sensor (11) is electrically connected to the control part.

10. The device for automatically distributing a wafer of a solar cell according to claim 1, **characterized in that** the stack uploading area (5) comprises a stack receiving basket (5-1), a transport device, a linkage device, a driving device, and a suction cup (5-2), wherein the stack receiving basket (5-1) is located at one side of the transport device, and the linkage device is located directly above the transport device for driving a lifting device to move forward or backward of the transport device, wherein the driving device is slidably mounted on the linkage device, and the suction cup (5-2) is fixedly mounted on the lifting device.

11. The device for automatically distributing a wafer of a solar cell according to claim 3 or 8, **characterized in that** the clamping device comprises a driving device, wherein the driving device is fixedly mounted above the fixed table (2-1), and the driving device is fixedly mounted with a clamping plate (6-1), wherein the clamping plate (6-1) is located directly above the transport device, and the driving device is arranged in driving the clamping plate (6-1) closer to or away from the transport device.

12. The device for automatically distributing a wafer of a solar cell according to claim 3 or 8, **characterized in that** the movable conveying device comprises a frame and a belt (6-2), wherein the frame is fixedly mounted with a first rotating shaft (6-3) and a second rotating shaft (6-4), a third rotating shaft (6-5) and a fourth rotating shaft (6-6) are slidably mounted on the frame, wherein the first rotating shaft (6-3) and the fourth rotating shaft (6-6) are located on the same horizontal plane, and the first rotating shaft (6-3), the second rotating shaft (6-4), the third rotating shaft (6-5) and the fourth rotating shaft (6-6) each are fixedly mounted with a pulley (6-7), wherein the belt (6-2) is wound sequentially around the pulleys (6-7) on the first rotating shaft (6-3), the second rotating shaft (6-4), the third rotating shaft (6-5), and the four rotating shaft (6-6), and the frame is fixedly mounted with a pushing cylinder, protruding ends of two pushing cylinders are fixedly connected to the third rotating shaft (6-5) and the fourth rotating shaft (6-6) respectively, the two pushing cylinders respectively drive the third rotating shaft (6-5) and the fourth rotating shaft (6-6) to move left and right on the frame, wherein the frame is fixedly mounted with a pressure sensor, and the pressure sensor is located on the left side of the fourth rotating shaft (6-6), and the pressure sensor is electrically connected to the control part.

13. The device for automatically distributing a wafer of a solar cell according to claim 2 or 3 or 4 or 6 or 8 or 9, **characterized in that** the transport device is a belt conveyor (8) having two groups of conveying tracks (4-2-3) in parallel and spaced apart, and the belt conveyor (8) is electrically connected to the control part.

14. The device for automatically distributing a wafer of a solar cell according to claim 3 or 4 or 8, **characterized in that** the linkage device is a screw drive device (9) that is electrically connected to the control part.

15. The device for automatically distributing a wafer of a solar cell according to claim 13, **characterized in that** the wafer distribution track group comprises two U-shaped plates (4-2-1) in parallel and spaced apart, one of the U-shaped plates (4-2-1) is inserted between two groups of conveying tracks (4-2-3) in the belt conveyor (8) of the moving mechanism (4-1), a conveying track (4-2-3) is disposed on the U-shaped plate (4-2-1) for driving the cell wafer to move, and the conveying track (4-2-3) is electrically connected to the control part.

16. The device for automatically distributing a wafer of a solar cell according to claim 7, **characterized in that** the guiding device comprises a guiding plate (4-2-2), and two guiding plates (4-2-2) are respectively located on two sides of the transport device, the two guiding plates (4-2-2) are all arranged in parallel to the transport device, and the guiding plate (4-2-2) is provided with a guide opening (4-2-2-1), and two guide openings (4-2-2-1) are symmetrically arranged.

17. The device for automatically distributing a wafer of a solar cell according to claim 1, **characterized in that** the control part is a programmable logic controller.
